Europäisches Patentamt

European Patent Office

Office européen des brevets

(11) Veröffentlichungsnummer: **0 368 029 B1**

# EUROPÄISCHE PATENTSCHRIFT

(45) Veröffentlichungstag der Patentschrift: **01.06.94**

(51) Int. Cl.⁵: **G01R 31/00**

(21) Anmeldenummer: **89119127.2**

(22) Anmeldetag: **14.10.89**

(54) **Messverfahren und Schaltungsanordnung zur Ueberprüfung von Schutzmassnahmen in Wechselspannungsnetzen.**

(30) Priorität: **20.10.88 DE 3835710**

(43) Veröffentlichungstag der Anmeldung:
**16.05.90 Patentblatt 90/20**

(45) Bekanntmachung des Hinweises auf die
Patenterteilung:
**01.06.94 Patentblatt 94/22**

(84) Benannte Vertragsstaaten:
**AT CH DE FR GB IT LI NL**

(56) Entgegenhaltungen:
**DE-A- 3 421 829**
**DE-A- 3 421 873**
**DE-B- 2 658 185**

(73) Patentinhaber: **Gossen- Metrawatt GmbH**
**Thomas-Mann-Strasse 20**
**D-8500 Nürnberg(DE)**

(72) Erfinder: **Ziegler, Herbert**
**Hartensteiner Strasse 66**
**D-8500 Nürnberg(DE)**
Erfinder: **Clever, Carl W.**
**Wittelsbacher Strasse 79a**
**D-8500 Nürnberg 50(DE)**

(74) Vertreter: **Hafner, Dieter, Dr.rer.nat.,**
**Dipl.-Phys. et al**
**Dr. Hafner & Stippl,**
**Patentanwälte,**
**Ostendstrasse 132**
**D-90482 Nürnberg (DE)**

**Beschreibung**

Die Erfindung betrifft ein Meßverfahren zur Überprüfung von Schutzmaßnahmen in Wechselspannungsnetzen, bei dem die Berührungsspannung und ggf. weitere Meßgrößen mittels eines über die Netzanschlüsse geführten als steuerbare last wirkenden Konstantstroms ermittelt wird und die Zeitspanne, während der ein Konstantstrom fließen kann, auf einen Höchstwert begrenzt ist, der bei Berührungsspannungen über dem zulässigen Wert eine Gefährdung ausschließt. sowie eine Schaltungsanordnung zur Durchführung dieses Verfahrens.

Bei der Überprüfung von Schutzmaßnahmen in Wechselspannungsnetzen werden unter anderem die Berührungsspannung $U_B$, der Netzinnenwiderstand $R_i$, der Schleifenwiderstand $R_{Schl}$, der Erdungswiderstand $R_E$ und das Abschaltverhalten von Fehlerstromschutzschaltern (FI-Schaltern) ermittelt. Hierzu ist es erforderlich, den Schutzleiter PE des jeweiligen Netzes mit einem Prüfstrom zu beaufschlagen. Bei fehlerhaften Netzen kann nun durch diesen Prüfstrom am Schutzleiter eine gefährliche Berührungsspannung entstehen.

Nach VDE gilt eine Berührungsspannung erst dann als gefährlich, wenn sie bestimmte Grenzwerte, bei Wohnräumen z.B. 50 V, überschreitet. Doch auch größere Werte sind dann zulässig, wenn sie auf eine maximale Zeit von 200ms begrenzt sind.

Bekannte Prüfgeräte zur Überwachung der Schutzmaßnahmen nach VDE 0100 erfüllen die vorstehenden Bedingungen, indem die Dauer, während der ein Prüfstrom fließt, auf 0,2 s begrenzt wird. Bei einer Periodendauer von 20 ms in 50 Hz Netzen stehen für die Messung somit 10 Perioden zur Verfügung, was im allgemeinen ausreicht.

Mit dem technischen Fortschritt steigen jedoch auch die Anforderungen bezüglich der elektrischen Sicherheit. So empfiehlt die KEMA für den territorialen Bereich der Niederlande bereits eine maximale Zeit von 40 ms für Berührungsspannungen über 50 V und es ist damit zu rechnen, daß auch Deutschland nachziehen wird.

Den Meßablauf auf eine Zeitspanne von 40 ms zu beschränken, ist in vielen Fällen nicht möglich oder zumindest unzweckmäßig, da eine ausreichende, Schwankungen weitgehend eliminierende Meßgenauigkeit nur erzielbar ist, wenn über mehr als 2 Perioden der Netzwechselspannung gemessen werden kann.

Aus der DE-A-34 21 873 (EP-A-0 165 512) ist ein Meßverfahren bekannt, das die Messung von Berührungsspannungen erlaubt und bei dem zur Messung nach der Spannungsabsenkungsmethode während mehrerer Perioden ein Laststrom fließt. Vor jeder Lastperiode liegt eine Leerlaufperiode, so daß die Netzspannung sowohl bei Leerlauf als auch bei Belastung gemessen werden kann. Die Differenzspannung zwischen der gemessenen Leerlaufspannung und der Lastspannung entspricht der zu ermittelnden Berührungsspannung, sofern zwischen dem L- und dem PE-Leiter des Netzes gemessen wird. Bei dem vorbekannten Verfahren wird die Differenzspannung auf besonders einfache Weise dadurch erfaßt, daß die beiden gleichgerichteten Halbwellen der Leerlaufspannung aufintegriert und die beiden folgenden gleichgerichteten Halbwellen abintegriert werden. Die im Integrator verbleibende Restspannung entspricht der gesuchten Differenzspannung.

Durch die unmittelbare Reihenfolge von Auf- und Abintegration über jeweils eine Periode, ist die Gefahr, daß Netzspannungsschwankungen mitgemessen werden, geringer als bei Verfahren, bei denen Pausenzeiten zwischen der Erfassung beider Wechselspannungen auftreten. Schließen sich an einen aus zwei Perioden bestehenden Integrationszyklus weitere Integrationszyklen an, so steigt der im Integrator verbleibende Spannungswert und dieser ist nunmehr durch die Zahl der Integrationszyklen zu teilen, um die gesuchte Differenzspannung zu erhalten.

Durch diese Maßnahme werden zwei wesentliche Vorteile erzielt. So wird der Einfluß von Netzspannungsschwankungen erheblich reduziert, da eine quasi statistische Mittelwertbildung erfolgt. Weiterhin führt das Integrieren über mehrere Meßzyklen besonders bei kleinen Differenzspannungen zu höheren Spannungsabsolutwerten, die besser und genauer erfaßbar sind.

Aus DE-A-26 58 185 ist weiterhin eine Schaltungsanordnung zur Erzeugung eines Prüfstromes zwecks Prüfung von Schutzschaltern bekanntgeworden, bei welcher beim Überschreiten eines ermittelten Grenzwertes der Berührungsspannung (Spannung zwischen Schutzleiter und Erde) während des automatischen Anstieges des Prüfstromes über eine elektronische Verstärkeranordnung der Prüfstromfluß unterbrochen wird.

Aus DE-A-3 421 829 geht außerdem ein Meßverfahren hervor, bei welchem nur eine Testmessung zur Ermittlung der Berührungsspannung am Ende des Kompletten Hauptmeßzyklus durchgeführt wird. Aufgrund der unter Umständen längerfristig austehenden Berührungsspannung kann dies eine Gefährdung für die messende Bedienungsperson sowie von die zu vermessende Anlage berührenden Dritten herbeiführen.

Aufgabe der Erfindung ist es, ein Meßverfahren der im Oberbegriff des Anspruchs 1 genannten Art zu schaffen, das es erlaubt zur Durchführung der Überprüfung von Schutzmaßnahmen in Wechselspannungsnetzen mit einem Prüfstrom zu arbeiten, der in mindestens drei aufeinanderfolgenden Perioden fließt, aber dennoch eine Gefährdung durch zu hohe Berührungsspannung ausgeschlossen wird. Weiterhin soll eine zur Durchführung des Meßverfahrens geeignete Schaltungsanordnung vorgeschlagen werden.

Diese Aufgabe wird durch die in den Ansprüchen 1 und 15 gekennzeichneten Merkmale gelöst. Zweckmäßige Ausgestaltungen und Weiterbildungen der Erfindung sind in den Unteransprüchen genannt.

Die erfindungsgemäße Lösung gestattet es, die zur Ermittlung einer bestimmten Meßgröße dienende Hauptmessung einerseits und die im Gefahrenfall eine Sicherheitsabschaltung des Prüfstroms bewirkende Testmessung andererseits, zeitlich parallel laufen zu lassen. Da die Testmessungen jedoch im Gegensatz zur Hauptmessung so schnell ablaufen, daß ihr Ergebnis vorliegt, bevor die Sicherheitszeit von 40 ms abgelaufen ist, kann der Prüfstrom noch innerhalb dieser Zeit abgeschaltet werden. Die Hauptmessung kann erst durchgeführt werden, wenn die Ursache für die unzulässig hohe Berührungsspannung beseitigt wurde. Eine Gefährdung durch zu hohe Berührungsspannungen wird somit vermieden.

Obwohl es genügt, wenn die Abschaltung des Prüfstroms innerhalb von 2 Perioden (40 ms) erfolgt, sieht eine zweckmäßige Weiterbildung des Erfindungsgegenstandes vor, daß die Auswertung der Testmessung bereits nach einer Periode erfolgt. Stellt man in Rechnung, daß für die Auswertung der Testmessung und den Abschaltvorgang zusätzlich Zeit beansprucht wird, so liegt diese auf jeden Fall innerhalb einer Periode, so daß nach längstens 2 Perioden abgeschaltet werden kann.

Zur Vereinfachung des Meßverfahrens sollen für die Testmessung möglichst Werte herangezogen werden, die bereits bei der Hauptmessung anfallen. Weiterhin soll zur Minimierung des Hardware-Aufwandes bei den verschiedenen zur Ermittlung unterschiedlicher Meßgrößen dienenden Hauptmessungen, immer mit der gleichen Schaltungsanordnung gearbeitet werden. Letzteres bedeutet, daß z.B. nicht sowohl bei der Hauptmessung, als auch bei der Testmessung gleichzeitig integriert werden kann, wenn nur ein Integrator zur Verfügung steht. Die jeweilige Testmessung muß somit an die Hauptmessung angepaßt werden.

Eine vorteilhafte Weiterbildung der Erfindungsgegenstandes sieht deshalb vor, daß bei solchen Hauptmessungen, bei denen die Meßgröße mit Hilfe der Spannungsabsenkungsmethode ermittelt wird, die nach Abschluß eines Integrationszyklusses am Ausgang des Integrators verbleibende Spannung als Testwert für die Testmessung dient. Die Abschaltung des als Prüfstrom dienenden Konstantstroms erfolgt, sobald ein vorgegebener Limitwert überschritten wird. Der Limitwert enspricht dem Grenzwert der zulässigen Berührungsspannung. Da die Ausgangsspannung am Integrator nach jedem Integrationszyklus ansteigt, muß auch der Limitwert entsprechend erhöht werden.

Eine besonders einfache Methode zur Abschaltung des Konstantstroms besteht darin, diesen bei jeder Halbwelle neu einzuschalten und den hierfür erforderlichen Einschaltimpuls zur Bewirkung der Abschaltung zu unterdrücken.

Eine andere Art von Hauptmessung erfolgt bei der Überprüfung des Ausschaltverhaltens von FI-Schaltern. Hierbei wird das mit dem FI-Schalter versehene Netz entweder mit einem gleichbleibenden Konstantstrom, der dem Nennfehlerstrom entspricht oder mit einem in Stufen ansteigenden Konstantstrom beaufschlagt. Im ersten Fall mißt man die Zeit bis zum Auslösen des FI-Schalters, und im zweiten Fall mißt man den Strom, bei dem der FI-Schalter auslöst. In beiden Fällen muß der Konstantstrom über eine Vielzahl von Perioden fließen, um die Hauptmessung vorschriftsmäßig durchführen zu können.

In einer Weiterbildung der Erfindung ist vorgesehen, in Verbindung mit einer Hauptmessung zur Überprüfung von FI-Schaltern zunächst eine Pilotmessung durchzuführen, bei der die Netzspannung im Leerlauf erfaßt wird. Dieser Spannungswert wird gespeichert und dient als Referenzwert für sich anschließende Spannungsmessungen unter Belastung mit einem vorgegebenen Konstantstrom. Letztere dienen als Testmessungen, die jeweils in der ersten Halbwelle einer Periode durchgeführt und in der zweiten Halbwelle ausgewertet werden. Auch hier kann also bei überhöhter Berührungsspannung bereits nach einer Periode ein Abschaltbefehl gegeben werden. Die jeweilige Berührungsspannung ergibt sich aus der Differenz zwischen dem gespeicherten Referenzwert und dem jeweiligen momentanen Testwert.

Für die Durchführung der Messung ist wichtig, daß der Konstantstrom programmierbar ist und damit in seinem Wert automatisch geändert werden kann. So werden je nach Art der Hauptmessung unterschiedliche Konstantströme benötigt. Bei den Hauptmessungen nach der Spannungsabsenkungsmethode wird der Konstantstrom vorzugsweise auf 30 % des Nennfehlerstroms im Netz liegender FI-Schalter programmiert, damit die Messung durchgeführt werden kann, ohne daß der FI-Schalter abschaltet. Die Abschaltzeit des FI-Schalters wird mit dem Nennfehlerstrom festgestellt und sein Abschaltstrom mit Hilfe eines in Stufen erhöhten Konstantstroms ermittelt.

Eine zu hohe Berührungsspannung wird gegebenenfalls vorgetäuscht, wenn z.B. der FI-Schalter im Laufe der Messung abgeschaltet hat aber zum Zeitpunkt der Pilotmessung noch eingeschaltet war, so daß die Differenzspannung dem Wert der Referenzspannung entspricht. Um diesen Fall auszuschließen, wird vor der Meldung einer gefährlichen Berührungsspannung noch das Anliegen der Netzspannung geprüft.

Weiterhin ist es möglich, daß der FI-Schalter bei seiner Überprüfung mit dem Nennfehlerstrom nicht innerhalb der vorgeschriebenen Zeit abgeschaltet hat. Eine Fehlermeldung erfolgt jedoch erst dann, wenn feststeht, daß in der letzten Periode des Prüfablaufs der Konstantstrom noch fließt. Nach Ablauf der automatischen Messung wird nämlich auch ohne daß der FI-Schalter den Stromkreis unterbricht der Konstantstrom abgeschaltet.

Für die im Rahmen des erfindungsgemäßen Meßverfahrens vorgesehene Sicherheitsabschaltung durch Unterbrechung des Konstantstroms, ist im Hinblick auf die Schaltungsanordnung der Lastzweig von besonderer Bedeutung. Er beinhaltet zwei in Reihe liegende Glieder, die beide ein Abschalten des Konstantstroms ermöglichen. So wird, wie bereits erläutert, bei zu hoher Berührungsspannung der Einschaltimpuls, der die nächste Halbwelle des Konstantstroms auslöst, unterdrückt, so daß die Konstantstromschaltung keinen Strom mehr abgibt. Gleichzeitig wird jedoch auch das Relais betätigt das den Stromkreis noch während der anstehenden Halbwelle unterbricht. Das Relais wirkt somit schneller und besitzt auch ein höheres Abschaltvermögen. Mit Hilfe der Stromüberwachung läßt sich eine Unterbrechung des Stromkreises auf einfache Weise verifizieren.

Ein Ausführungsbeispiel der Erfindung ist in den Zeichnungen dargestellt und wird im folgenden näher beschrieben.

Es zeigen:

Figur 1: Eine Schaltungsanordnung zur Durchführung des erfindungsgemäßen Verfahrens,

Figur 2: Strom- und Spannungsdiagramme über mehrere Perioden des Meßablaufs bei einer Messung nach der Spannungsabsenkungsmethode,

Figur 3: Strom- und Spannungsdiagramme über mehrere Perioden eines Meßablaufs zur Prüfung des Ausschaltverhaltens eines FI-Schalters,

Figur 4: Verlauf des stufig ansteigenden Konstantstroms zur Ermittlung des Auslösestroms und der zugehörigen Berührungsspannung.

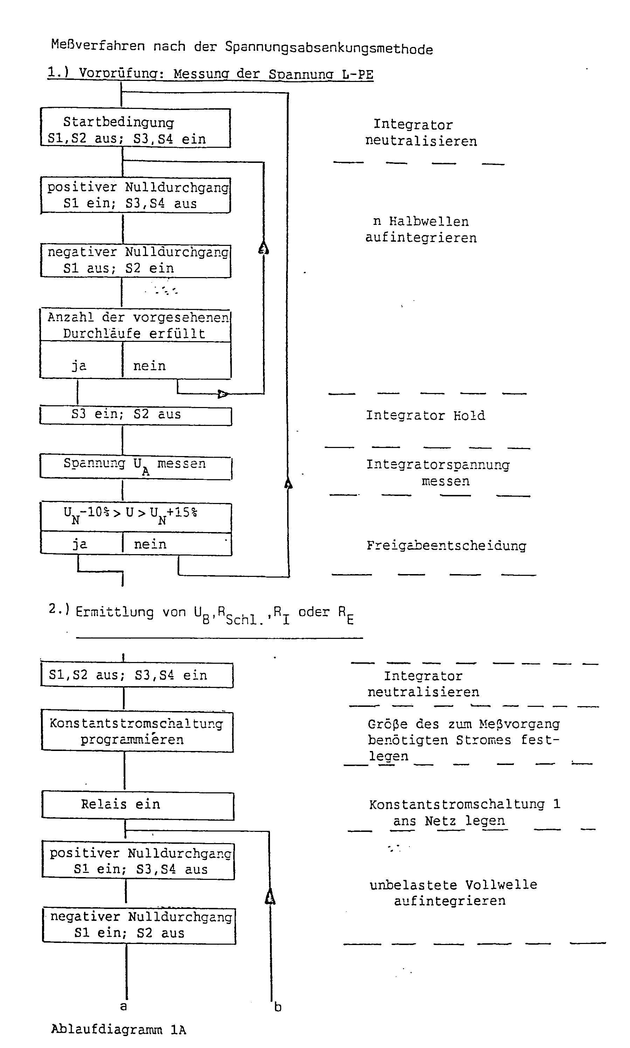

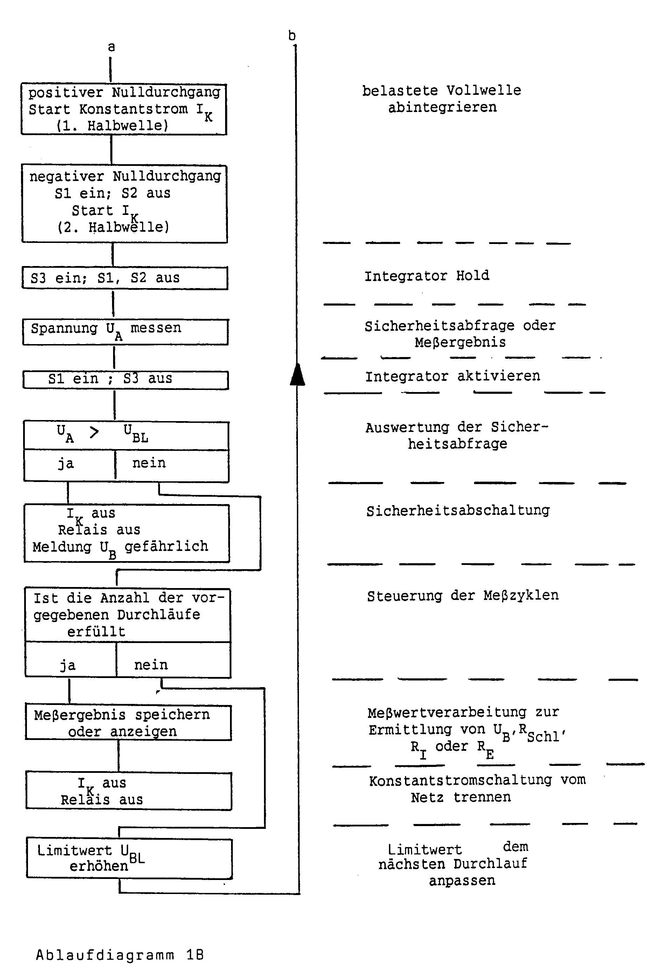

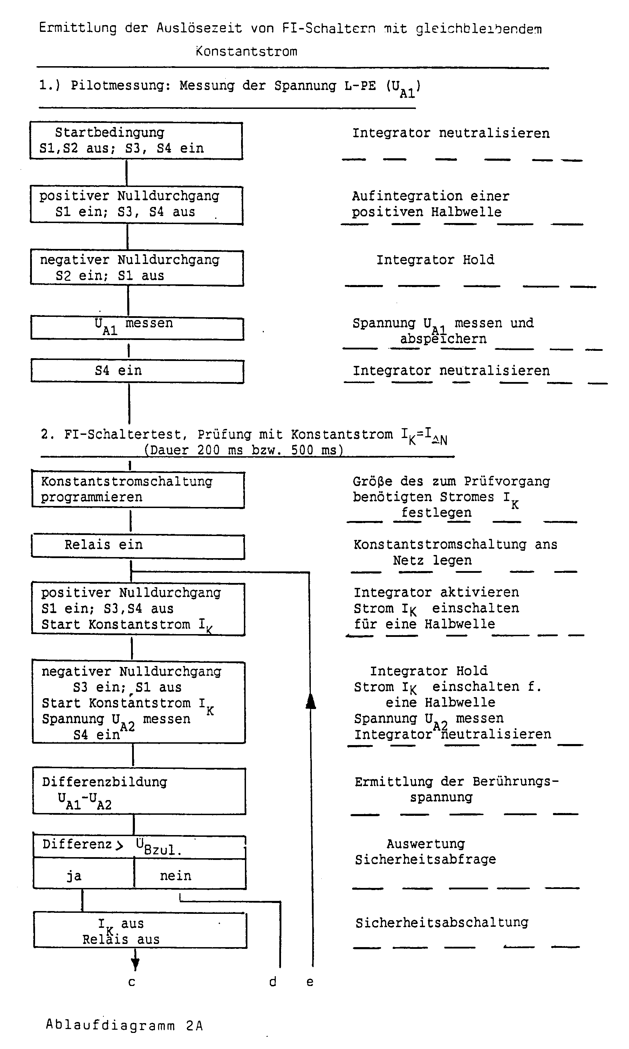

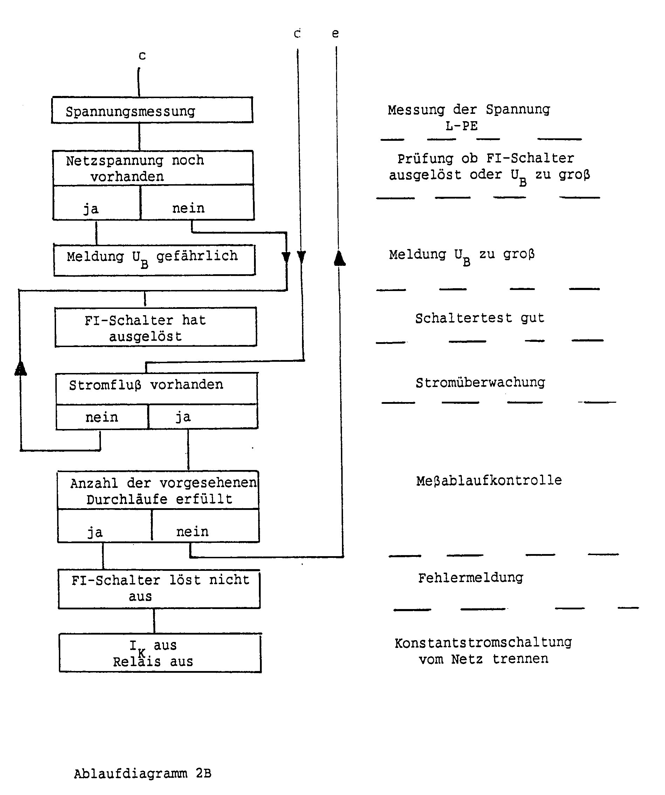

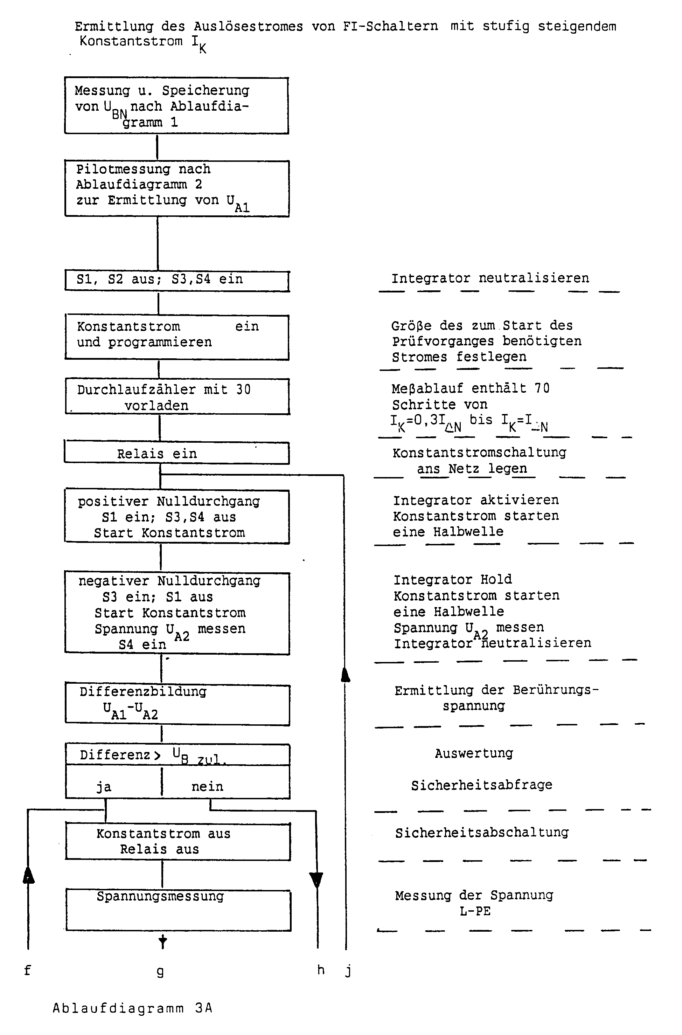

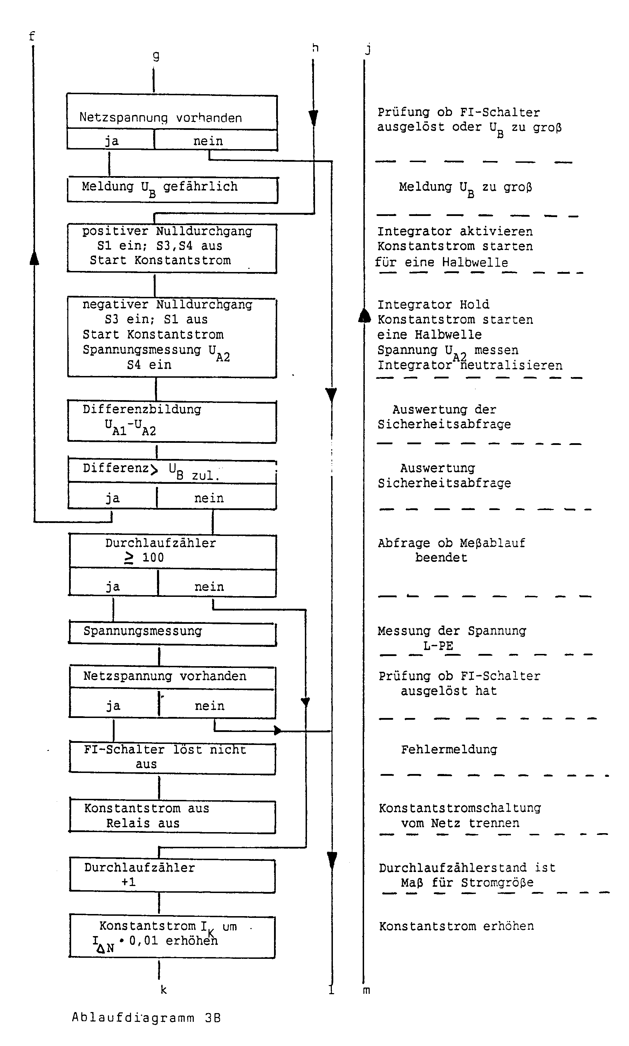

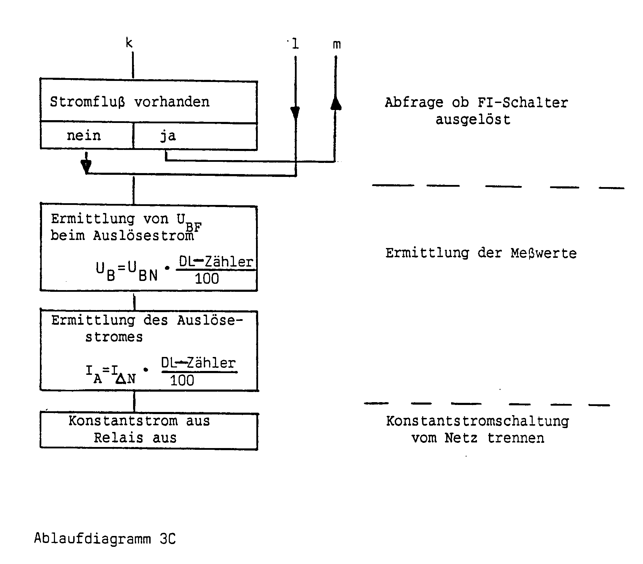

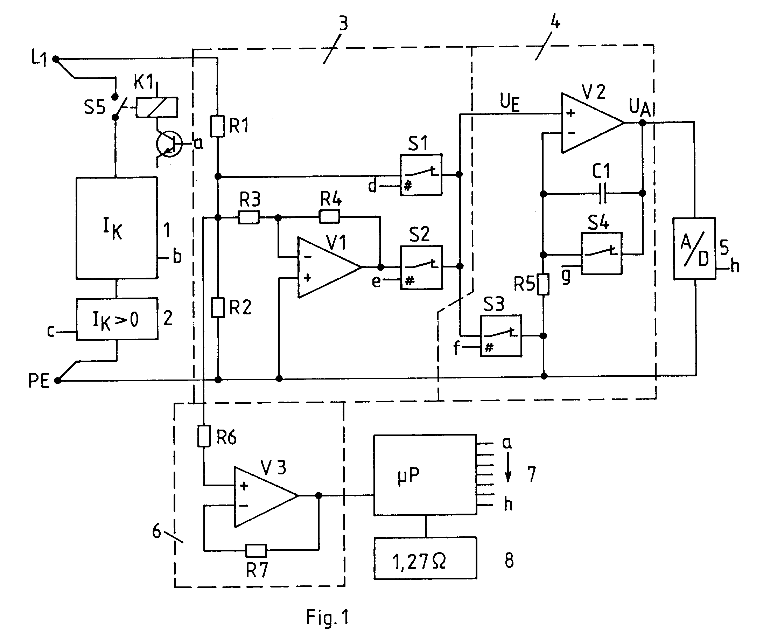

Die in Figur 1 dargestellte Schaltungsanordnung dient zur Durchführung verschiedener Meßverfahren, wobei unterschiedliche Meßgrößen ermittelt werden, die eine Überprüfung von Schutzmaßnahmen in Wechselstromnetzen ermöglichen. Die Schaltung enthält einen gesteuerten Zweiweggleichrichter 3, der mit seinem Eingang zwischen Phase L1 und dem Schutzleiter PE eines zu überprüfenden Wechselspannungsnetzes angeschlossen ist. Je nach Art der durchzuführenden Messung könnte der zweipolige Eingang auch zwischen Phase und Null-Leiter angeschlossen sein. Am Ausgang des gesteuerten Zweiweggleichrichters 3 liegt ein gesteuerter Integrator 4, dem ein A/D-Wandler 5 nachgeschaltet ist. Einem Mikroprozessor 7 wird das Ausgangssignal des A/D-Wandlers 5 sowie eines Null-Detektors 6 zugeführt. Der Null-Detektor 6 liegt mit seinem Eingang an einem Spannungsteiler R1, R2, der die Netzanschlüsse L1, PE miteinander verbindet und gleichzeitig auch den Eingang des gesteuerten Zweiweggleichrichters 3 bildet.

Die vom Spannungsteiler R1, R2 herabgesetzte Netzspannung wird von seinem Abgriff einem ersten gesteuerten Schalter S1 zugeführt, der am Eingang des Integrators 4 liegt. Einem zweiten ebenfalls mit dem Eingang des Integrators 4 verbundenen gesteuerten Schalter S2 ist ein invertierender Verstärker V1,R3,R4 vorgeschaltet, dessen Eingang an dem Abgriff des Spannungsteilers R1, R2 liegt.

Zu dem gesteuerten Integrator 4 gehören ein Verstärker V2, der eingangsseitig von einem dritten gesteuerten Schalter S3 überbrückt ist, und in dessen Gegenkopplungszweig ein Ladekondensator C1 liegt, dem ein vierter gesteuerter Schalter S4 parallel geschaltet ist.

Am Eingang der Schaltungsanordnung zwischen Phase L1 und Schutzleiter PE ist ein Lastzweig angeschlossen, der aus der Reihenschaltung eines Relaisschalters S5, einer Konstantstromschaltung 1 und einer Stromüberwachung 2 besteht. Der Relaisschalter S5 wird über ein Relais K1 betätigt, das seinerseits über den an einem vorgeschalteten Transistor liegenden Steueranschluß a vom Rechner 7 gesteuert wird. Weitere Steueranschlüsse b bis h sind ebenfalls mit dem Rechner verbunden, der über den A/D-Wandler 5 die jeweiligen Meßwerte abfragt und nach ihrer Auswertung das Meßergebnis auf einem Display 8 zur Anzeige bringt.

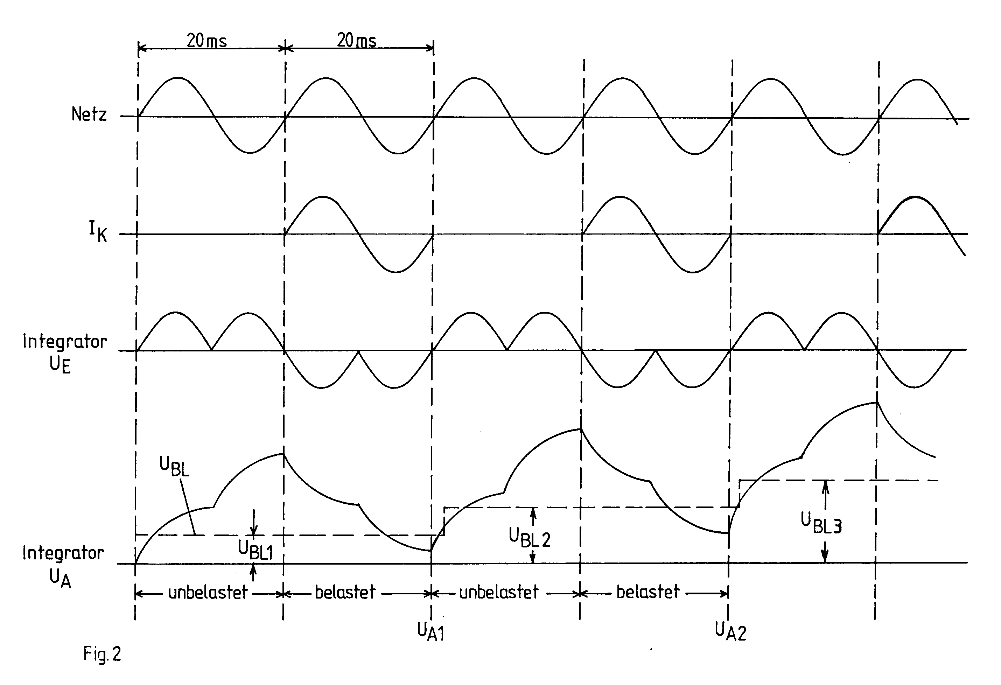

Die in Figur 2 dargestellten Diagramme sollen einen Meßablauf verdeutlichen, wie er bei der Messung der Berührungsspannung, des Netzinnenwiderstandes, des Schleifenwiderstandes und des Erdungswiderstandes zur Anwendung kommt. Bei der Ermittlung dieser Meßgrößen wird nach der Methode der Spannungsabsenkung verfahren. Das bedeutet, daß auf eine Leerlaufphase eine Lastphase folgen muß, so daß die Netzspannung sowohl im Leerlauf als auch unter Last gemessen werden kann. Der Differenzwert dieser beiden Spannungen ist der gesuchten Meßgröße proportional. Im vorliegenden Fall ist die Dauer der Last- und der Leerlaufphase auf jeweils eine Periode festgelegt. Der die Last bildende Konstantstrom $I_K$ wird somit nach einer Periode jeweils für die Dauer einer weiteren Periode unterbrochen. Es wird mit einem Konstantstrom $I_K$ gearbeitet, um Lastschwankungen, die das Meßergebnis verfälschen könnten, zu vermeiden.

Das Diagramm der am Eingang des Integrators 4 anliegenden Eingangsspannung $U_E$ verdeutlicht die Wirkungsweise des gesteuerten Zweiweggleichrichters 3. Der invertierende Verstärker V1, R3,R4 sorgt dafür, daß die am gesteuerten Schalter S2 anliegende Netzwechselspannung um 180° gegenüber der am gesteuerten Schalter S1 anliegenden Spannung in der Phase verschoben wird. Die beiden gesteuerten Schalter S1,S2 werden nun so geschaltet, daß sie eine Gleichrichtung bewirken aber derart, daß sich die Polarität der gleichgerichteten Wechselspannung nach jeweils einer Periode umkehrt. Somit folgen jeweils auf zwei positive Halbwellen zwei negative Halbwellen. Die negativen Halbwellen entsprechen der Lastphase und besitzten dementsprechend eine etwas geringere Amplitude als die im Leerlauf gemessenen positiven Halbwellen.

Das Diagramm der Ausgangsspannung $U_A$ am Ausgang des Integrators 4 läßt dessen Wirkungsweise erkennen. Die beiden positiven Halbwellen der Eingangsspannung $U_E$ werden zunächst aufintegriert und anschließend mit den beiden negativen Halbwellen abintegriert. Da die Amplitude der negativen Halbwelle durch die Belastung geringer ist, verbleibt am Integratorausgang eine Restspannung $U_A$, die der Differenz zwischen Last- und Leerlaufspannung entspricht.

Um die verbleibende Restspannung zu erhöhen und damit die Meßgenauigkeit zu verbessern, folgen jeweils mehrere Integrationszyklen aufeinander, wobei jeder Integrationszyklus sich über zwei Perioden erstreckt. Die nach dem letzten Integrationszyklus am Ausgang des Integrators 4 verbleibende Ausgangsspannung wird mit Hilfe des Rechners durch die Zahl der Integrationszyklen geteilt und ergibt danach einen Mittelwert, in dem Schwankungen einzelner Perioden weitgehend eliminiert sind.

Der in der Lastphase fließende Konstantstrom $I_K$ könntebei fehlerhaftem Netz zu einer gefährlichen Berührungsspannung führen. Eine genaue Messung der Berührungsspannung über mehrere Integrationszyklen erfordert eine weit längere Zeit als 40 ms. Damit im Gefahrenfall bei zu hoher Berührungsspannung der Konstantstrom $I_K$ sofortabgeschaltet werden kann, wird nach jedem Integrationszyklus eine Testmessung vorgenommen, bei der die während der Hauptmessung ermittelte Ausgangsspannung $U_A$ mit einem vorgegebenen Limitwert $U_{BL}$ verglichen wird. Der Limitwert $U_{BL}$ entspricht der oberen Grenze, der noch zulässigen Berührungsspannung $U_B$ und muß nach jedem Integrationszyklus erhöht werden. Da die Ausgangsspannung am Integrator $U_{A2}$ etwa den doppelten Wert von $U_{A1}$ erreicht, muß auch $U_{BL2}$ auf den doppelten und $U_{BL3}$ auf den dreifachen Wert von $U_{BL1}$ festgelegt werden.

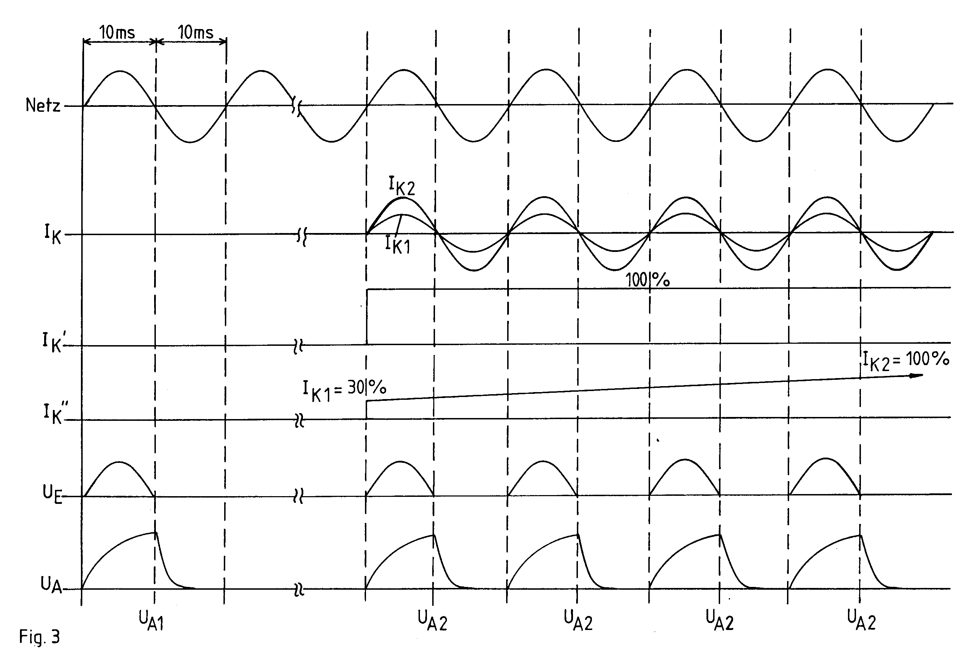

Die in Figur 3 dargestellten Diagramme sollen den Meßablauf bei der Überprüfung eines FI-Schalters verdeutlichen. Sein Schaltverhalten wird wiederum mit einem Konstantstrom $I_K$ untersucht. Zur Ermittlung der Ausschaltzeit wird ein mit $I_K$, gekennzeichneter Konstantstrom vorgegeben, der nach dem Einschalten auf den vollen Wert des Nennfehlerstroms des jeweilen FI-Schalters springt. Die Amplitude des Konstantstroms könnte einen Wert $I_{K2}$ erreichen, der bis zum Ansprechen des FI-Schalters konstant gehalten und erst nach Abschluß der Messung abgeschaltet wird.

Den Wert des Stroms, bei dem der FI-Schalter abschaltet, kann man ermitteln, indem man die Amplitude des Konstantstroms von einem niedrigen Wert $I_{K1}$ stetig oder stufig erhöht. Wie durch die Kurve $I_{K''}$ angedeutet ist, erreicht der Konstantstrom nach dem Einschalten einen Basiswert von 30 % des Fehlernennstroms und steigt dann bis 100 % an. Die Konstantstromschaltung 1 ist so programmiert, daß der Konstantstrom in Stufen von 1 % ansteigt, so daß sich unmittelbar aus dem beim Abschalten erreichten Stufenwert des Abschaltstrom des FI-Schalters ergibt.

Der für die Hauptmessung nach Figur 2 ohnehin erforderliche Integrator 4 wird für die vorstehend erläuterte Hauptmessung nach Figur 3 nicht benötigt, so daß er für die zur Berührungsspannungsmessung erforderlichen Testmessungen herangezogen werden kann. Wie das Diagramm in Figur 3 erkennen läßt, werden die gesteuerten Schalter S1,S2 so geschaltet, daß jeweils nur die positive Halbwelle $U_E$ an den Eingang des Integrators 4 gelangt. Diese Spannung wird während der ersten Halbwelle einer Periode aufintegriert. Nach Übernahme des Ausgangsspannungswertes durch den Rechner 7 wird in der sich anschließenden Halbwelle der Integrator mit Hilfe der gesteuerten Schalter S3,S4, neutralisiert.

Die aus Sicherheitsgründen durchzuführende grobe Bestimmung der Berührungsspannung erfolgt derart, daß zunächst bei Leerlauf eine Pilotmessung durchgeführt wird und die hierbei ermittelte Ausgangsspannung $U_{A1}$ gespeichert wird. Nach Einschalten des Konstantstroms $I_K$ erfolgt eine erneute Messung der Ausgangsspannung, wobei ein Wert $U_{A2}$ ermittelt wird. Diese Messung wird in jeder Periode wiederholt. Die Differenz der beiden Spannungen $U_{A1}$ und $U_{A2}$ entspricht jeweiligen Berührungsspannung. Überschreitet die Berührungsspannung den zulässigen Wert, so werden die Konstantstromschaltung 1 und auch der Relaisschalter S5 abgeschaltet.

Ein wesentlicher Vorteil der Erfindung ist, daß alle Haupt- und Testmessungen mit der gleichen Schaltungsanordnung durchgeführt werden können, so daß für die Testmessungen bezüglich der erforderlichen Hardware kein Zusatzaufwand entsteht.

Die wichtigsten Schritte der vorstehend in ihrem Grundprinzip erläuterten Meßverfahren sind in drei Ablaufdiagrammen registriert. So zeigt das aus den Teilen 1A und 1B bestehende Ablaufdiagramm 1 die einzelnen Schritte des nach der Spannungsabsenkungsmethode arbeitenden Meßverfahrens. Der eigentlichen Messung zur Ermittlung der Berührungsspannung, des Schleifenwiderstandes, des Innenwiderstandes oder des Erdungswiderstandes ist eine Vorprüfung vorgeschaltet, die zur Messung der Netzwechselspannung L-PE dient. Ihr Spannungswert muß innerhalb der Grenzen von -10 % bis +15 % liegen, damit die Automatik des Meßgerätes den weiteren Meßablauf freigibt. Die einzelnen Schritte des Diagramms sind ausreichend gekennzeichnet, so daß sich weitere Erläuterungen erübrigen.

Das Ablaufdiagramm 2 mit den Teilen 2A und 2B beschreibt die Ermittlung der Auslösezeit von FI-Schaltern, die mit Hilfe eines gleichbleibenden Konstantstroms $I_K$ erfolgt. Hier wird der eigentlichen Messung die schon erläuterte Pilotmessung zur Ermittlung der Leerlaufspannung des Netzes vorangestellt.

Das Ablaufdiagramm 3 erläutert mit seinen Teilen 3A und 3B das zur Ermittlung des Auslösestroms von FI-Schaltern angewandte Verfahren, bei dem mit einem stufig steigenden Konstantstrom $I_K$ gearbeitet wird. Zum Verständnis des Ablaufs ist noch zu ergänzen, daß außer dem Abschaltstrom $I_\Delta$ auch die bei diesem Strom auftretende Berührungsspannung $U_B$ gemessen wird. Ermittelt man, wie im Ablaufdiagramm 3A dargestellt, am Anfang des Meßablaufs zunächst die bei Fehlernennstrom auftretende Berührungsspannung $U_{BN}$, so kann diese wie der Fehlernennstrom $I_{\Delta N}$ mit 100 % angesetzt werden.

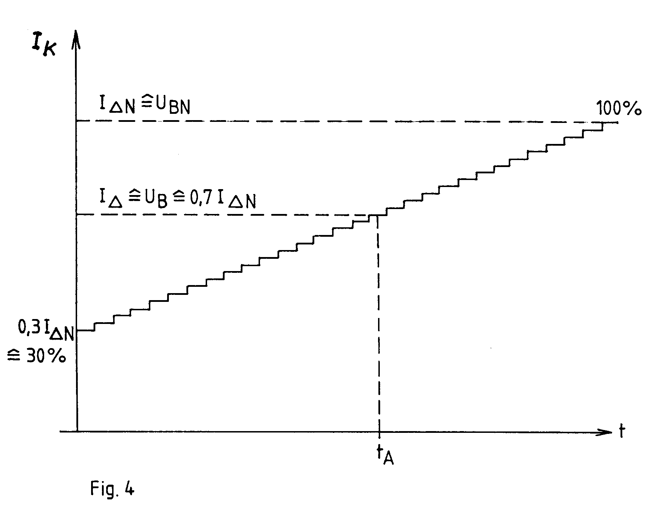

Wie in Figur 4 dargestellt, beginnt der Konstantstrom $I_K$ bei einem Wert von 30 % des Fehlernennstroms $I_{\Delta N}$ und steigt dann stufig an. Falls der FI-Schalter nicht abschaltet, würde $I_K$ am Ende der Messung 100 % erreichen, also dem Fehlernennstrom entsprechen. Löst der FI-Schalter bei 70 % seines Fehlernennstroms aus, so erreicht auch die zu diesem Zeitpunkt anliegende Berührungsspannung $U_B$ 70 % der Berührungsspannung $U_{BN}$ bei Nennfehlerstrom $I_{\Delta N}$. Mit Hilfe eines im Ablaufdiagramm genannten Durchlaufzählers (DL-Zähler), der die siebzig Stufen des jeweils um 1 % steigenden Konstantstroms zählt, kann man sowohl den Auslösestrom $I_\Delta$ als auch die zu diesem Zeitpunkt anliegende Berührungsspannung $U_B$ unmittelbar erfassen.

**Patentansprüche**

1. Meßverfahren zur Überprüfung von Schutzmaßnahmen in Wechselspannungsnetzen, bei dem die Berührungsspannung ($U_B$) und ggf. weitere Meßgrößen mittels eines über die Netzanschlüsse geführten als steuerbare Last wirkenden Konstantstroms ($I_K$) ermittelt wird und die Zeitspanne, während der ein Strom fließen kann, auf einen Höchstwert begrenzt ist, der bei Berührungsspannungen ($U_B$) über dem zulässigen Wert eine Gefährdung ausschließt,
wobei

a) bei einem Meßablauf, der eine Stromflußdauer erfordert, die über dem genannten Höchstwert liegt, während des Meßablaufs parallel zu einer Hauptmessung zur Überprüfung der Schutzmaßnahmen eine Mehrzahl von Testmessungen zur Ermittlung der zu erwartenden Berührungsspannung ($U_B$) durchgeführt werden;
b) nach jeder Testmessung ein Testwert ermittelt wird, der die zu erwartende Berührungsspannung ($U_B$) näherungsweise repräsentiert;
c) bei einer durch eine Testmessung ermittelten unzulässig hohen Berührungsspannung ($U_B$) eine Unterbrechung des Konstantstroms ($I_K$) erfolgt und
d) der Zeitabstand von einer Testmessung zur nächsten, plus der gegebenenfalls hinzukommenden Unterbrechungszeit für den Konstantstrom ($I_K$), kleiner ist als der genannte Höchstwert der Stromflußdauer.

2. Meßverfahren nach Anspruch 1, dadurch gekennzeichnet, daß die für die Testmessung erforderlichen Meßwerte nach Ablauf einer Periode des Konstantstroms ($I_K$) abgenommen und ausgewertet werden.

3. Meßverfahren nach einem der vorhergehenden Ansprüche, dadurch gekennzeichnet, daß die Zeitspanne vom Beginn des Stromflusses bis zu seiner Unterbrechung bei unzulässig hoher Berührungsspannung ($U_B$), kleiner als zwei Perioden, vorzugsweise kleiner als 1,5 Perioden des Konstantstroms ($I_K$) ist.

4. Meßverfahren nach einem der vorhergehenden Ansprüche, dadurch gekennzeichnet, daß bei einer Ermittlung der Meßgröße nach dem Spannungsabsenkungsverfahren die gleichgerichtete Netzspannung über eine Periode im Leerlauf aufintegriert und über eine sich anschließende Periode bei einer durch einen Konstantstrom ($I_K$) vorgegebenen Last abintegriert wird und die nach Abschluß dieses Integrationszyklusses am Ausgang des Integrators (4) verbleibende Ausgangsspannung ($U_A$) als Testwert für die Testmessung dient.

5. Meßverfahren nach einem der vorhergehenden Ansprüche, dadurch gekennzeichnet, daß die Ausgangsspannung ($U_A$) am Integrator (4) mit einem Limitwert ($U_{BL}$) verglichen wird, der die noch zulässige Berührungsspannung ($U_B$) repräsentiert und eine Unterbrechung des Konstantstromes ($I_K$) erfolgt, wenn die Ausgangsspannung ($U_A$) größer als der Limitwert ($U_{BL}$) ist.

6. Meßverfahren nach einem der vorhergehenden Ansprüche, dadurch gekennzeichnet, daß ein erster Limitwert ($U_{BL1}$) der in Verbindung mit einer ersten Ausgangsspannung ($U_{A1}$) im ersten Integrationszyklus vorgegeben wird, im zweiten Integrationszyklus mit einer zweiten Ausgangsspannung ($U_{A2}$) auf einen zweiten Limitwert ($U_{BL2}$) verdoppelt und im dritten Integrationszyklus verdreifacht wird, so daß nach n Integrationszyklen der Limitwert $U_{BLn} = n \cdot U_{BL1}$ erreicht wird.

7. Meßverfahren nach einem der vorhergehenden Ansprüche, dadurch gekennzeichnet, daß der Konstantstrom ($I_K$) bei Erreichen des Nulldurchgangs jeweils für die Dauer einer Halbwelle erneut eingeschaltet wird und eine Unterbrechung des Konstantstroms ($I_K$) durch Unterdrückung des Einschaltimpulses erfolgt.

8. Meßverfahren nach einem der vorhergehenden Ansprüche, dadurch gekennzeichnet, daß bei einer Überprüfung des Ausschaltverhaltens von FI-Schaltern eine Pilotmessung zur Erfassung der Netzspannung im Leerlauf durchgeführt wird und die hierzu über eine Halbwelle integrierte Leerlaufspannung ($U_{A1}$) gespeichert wird und daß der Pilotmessung weitere Messungen der Netzspannung, nunmehr während einer Belastung mit einem Konstantstrom ($I_K$) folgen, wobei die Netzspannung wiederum über je eine Halbwelle integriert und die in der jeweiligen Halbwelle gemessene Lastspannung ($U_{A2}$) mit der gespeicherten Leerlaufspannung ($U_{A1}$) verglichen wird.

9. Meßverfahren nach einem der vorhergehenden Ansprüche, dadurch gekennzeichnet, daß der Wert des Konstantstroms ($I_K$) programmierbar ist und der Konstantstrom mit jeder Halbwelle so oft erneut eingeschaltet wird, bis dies durch eine Sicherheitsunterbrechung oder nach Abschluß der FI-Schalterprüfung unterbunden wird und die Sicherheitsunterbrechung erfolgt, sobald die Differenzspannung zwischen der Leerlaufspannung ($U_{A1}$) und der Lastspannung ($U_{A2}$) den noch zulässigen Wert der Berührungsspannung ($U_B$) überschreitet.

10. Meßverfahren nach einem der vorhergehenden Ansprüche, dadurch gekennzeichnet, daß auf eine erste Halbwelle des Konstantstroms ($I_K$) während der die Integration zur Ermittlung der Lastspannung ($U_{A2}$) abläuft sich eine Auswertungsphase zur Ermittlung der Differenzspannung und ihrer Bewertung bezüglich der zulässigen Berührungsspannung ($U_B$) anschließt und während der sich über eine Halbwelle erstreckenden Auswertungsphase jeweils eine Neutralisation der Integrator-Ausgangsspannung ($U_A$) erfolgt.

11. Meßverfahren nach einem der vorhergehenden Ansprüche, dadurch gekennzeichnet, daß im Fall des Überschreitens der zulässigen Berührungsspannung ($U_B$) durch die ermittelte Differenzspannung ($U_{A1}$-$U_{A2}$) der somit gefährliche Wert erst gemeldet wird, wenn eine Prüfung ergeben hat, daß die Netzspannung noch anliegt.

12. Meßverfahren nach einem der vorhergehenden Ansprüche, dadurch gekennzeichnet, daß zur Klärung, ob der FI-Schalter nach erfolgter Überprüfung mit dem vorgegebenen Konstantstrom ($I_K$) innerhalb der vorgeschriebenen Zeit nicht ausgeschaltet hat und somit eine Fehlermeldung zu erfolgen hat, zuvor festgestellt wird, ob noch ein Konstantstrom ($I_K$) fließt.

13. Meßverfahren nach einem der vorhergehenden Ansprüche, dadurch gekennzeichnet, daß der FI-Schalter mit einem Konstantstrom ($I_K$) beaufschlagt wird, der während einer Prüfung, die zur Ermittlung der Ausschaltzeit dient, unverändert den Wert von 100% des Nennausschaltstromes ($I_{\Delta N}$) des FI-Schalters beibehält.

14. Meßverfahren nach einem der vorhergehenden Ansprüche, dadurch gekennzeichnet, daß der FI-Schalter mit einem Konstantstrom ($I_K$) beaufschlagt wird, der während einer Prüfung, die zur Ermittlung des Ausschaltstromes ($I_\Delta$) des FI-Schalters dient, in zeitlich festen Abständen in gleichen Stufen, vorzugsweise von 0,3 $I_{\Delta N}$ bis $I_{\Delta N1}$ ansteigt.

15. Schaltungsanordnung zur Durchführung des Meßverfahrens nach einem der vorhergehenden Ansprüche, dadurch gekennzeichnet, daß an zwei Netzspannungsanschlüssen (L1,PE) ein gesteuerter Zweiweggleichrichter (3) liegt, der eine gleichgerichtete Wechselspannung ($U_E$) dem Eingang eines Integrators (4) zuführt, dessen Ausgangsspannung ($U_A$) an einem A/D-Wandler (5) angeschlossen ist und weiterhin ein Rechner (7) das Ausgangssignal des A/D-Wandlers (5) verarbeitet und in Abhängigkeit hiervon und vom Ausgangssignal eines Nulldetektors (6) des Integrator (4), den Zweiweggleichrichter (3) und einen Lastzweig (S5,1,2) netzsynchron steuert, wobei der an den beiden Netzanschlüssen (L1,PE) anliegende Lastzweig (S5,1,2) aus der Reihenschaltung eines von dem Rechner (7) über ein Relais (K1) gesteuerten Schalters (S5), einer programmierbaren Konstantstromschaltung (1) und einer Stromüberwachung (2) besteht.

16. Schaltungsanordnung nach Anspruch 15, dadurch gekennzeichnet, daß der Zweiweggleichrichter (3) zwei mit seinem Ausgang verbundene steuerbare Schalter (S1,S2) besitzt, von denen der erste Schalter (S1) unmittelbare am Abgriff eines an den Netzanschlüssen (L1,PE) angeschlossenen Spannungsteilers (R1,R2) anliegt während der zweite Schalter (S2) über einen invertierenden Verstärker (V1,R3,R3) am Abgriff angeschlossen ist.

17. Schaltungsanordnung nach Anspruch 15 oder 16, dadurch gekennzeichnet, daß der Integrator (4) einen dritten und einen vierten steuerbaren Schalter (S3,S4) besitzt, von denen der dritte Schalter (S3) seinen Eingang gegen Bezugspotential (PE) kurzschließen kann und der vierte Schalter (S4) seinen Ladekondensator (C1) überbrückt.

**Claims**

1. Measuring method for testing protective measures in AC networks, in which the contact voltage ($U_B$) and, if necessary, further quantities to be measured, are determined by means of a constant current ($I_K$) which acts as a controllable load conducted through the network connections and the time interval during which a current can flow is limited to a maximum value which excludes risk when contact voltages ($U_B$) are above the permissible value, wherein

   a) in the course of a measurement which requires a current-flow duration above the said maximum value, a plurality of test measurements are carried out during the course of the measurement, in parallel with a main measurement for testing the protective measures, in order to determine the contact voltage ($U_B$) to be expected ;
   b) after each test measurement, a test value which approximately represents the contact voltage ($U_B$) to be expected is determined;
   c) when an unacceptably high contact voltage ($U_B$) is detected by a test measurement, the constant current ($I_K$) is interrupted, and
   d) the time interval from one test measurement to the next, plus any additional time for the interruption of the constant current ($I_K$), is shorter than the said maximum value of the duration of the current-flow.

2. Measuring method according to Claim 1, characterized in that the measured values required for the test measurement are taken and evaluated after one period of the constant current ($I_K$) has elapsed.

3. Measuring method according to any one of the preceding claims, characterized in that the time interval from the start of the current-flow to its interruption when there is an unacceptably high contact voltage ($U_B$) is shorter than two periods, preferably shorter than 1.5 periods, of the constant current ($I_K$).

4. Measuring method according to any one of the preceding claims, characterized in that, when a quantity to be measured is determined by the voltage-drop method, the rectified network voltage is integrated upwards over a period in open circuit and is integrated downwards over a subsequent period with a predetermined load given by a constant current ($I_K$), and the output voltage ($U_A$) remaining at the output of the integrator after the end of this integration cycle serves as the test value for the test measurement.

5. Measuring method according to any one of the preceding claims, characterized in that the output voltage ($U_A$) in the integrator (4) is compared with a limit value ($U_{BL}$) which represents the permissible contact voltage ($U_B$) and the constant current ($I_K$) is interrupted if the output voltage ($U_A$) is greater than the limit value ($U_{BL}$).

6. Measuring method according to any one of the preceding claims, characterized in that a first limit value ($U_{BL1}$) which is given in connection with a first output voltage ($U_{A1}$) in the first integration cycle is doubled to a second limit value ($U_{BL2}$) in the second integration cycle with a second output voltage ($U_{A2}$) and is trebled in the third integration cycle, so that, after n integration cycles, the limit value $U_{BLn} = n.U_{BL1}$ is reached.

7. Measuring method according to any one of the preceding claims, characterized in that, each time zero-crossing is reached, the constant current ($I_K$) is switched on again for the duration of one half wave, and an interruption of the constant current ($I_K$) takes place by the suppression of the switching pulse.

8. Measuring method according to any one of the preceding claims, characterized in that, in a test of the switching-off behaviour of residual-current breakers, a pilot measurement is carried out to acquire the network voltage in open circuit and the open-circuit voltage ($U_{A1}$) integrated for this over one half wave is stored, and in that the pilot measurement is followed by further measurements of the network voltage during loading, from this point on, with a constant current ($I_K$), the network voltage being integrated again over each half wave, and the load voltage ($U_{A2}$) measured in each half wave being compared with the open-circuit voltage ($U_{A1}$) stored.

9. Measuring method according to any one of the preceding claims, characterized in that the value of the constant current ($I_K$) is programmable and the constant current is switched on again with each half wave until it is stopped by a safety interruption or after the end of the test of a residual-current breaker, and the safety interruption takes place as soon as the voltage difference between the open-circuit voltage ($U_{A1}$) and the load voltage ($U_{A2}$) exceeds the permissible contact-voltage value ($U_B$).

10. Measuring method according to any one of the preceding claims, characterized in that a first half wave of the constant current ($I_K$), during which the integration to determine the load voltage ($U_{A2}$) takes place, is followed by an evaluation phase for determining the voltage difference and evaluating it in relation to the permissible contact voltage ($U_B$) and the integrator output voltage ($U_A$) is neutralized during each evaluation phase, which lasts for one half wave.

11. Measuring method according to any one of the preceding claims, characterized in that, in the event of the permissible contact voltage ($U_B$) being exceeded by the voltage difference ($U_{A1} - U_{A2}$) determined, the value, which is consequently dangerous, is indicated only when a test has revealed that the network voltage is still connected.

12. Measuring method according to any one of the preceding claims, characterized in that in order to clarify whether the residual-current breaker has not switched off within the prescribed time after a test has been carried out with the predetermined constant current ($I_K$) and a fault indication should thus result, it is first determined whether a constant current ($I_K$) is still flowing.

13. Measuring method according to any one of the preceding claims, characterized in that the residual-current breaker is subjected to a constant current ($I_K$) which, during a test which serves to determine the disconnection time, keeps the value of 100% of the nominal switching-off current ($I_{\Delta N}$) of the residual-current breaker unchanged.

14. Measuring method according to any one of the preceding claims, characterized in that the residual-current breaker is subjected to a constant current ($I_K$) which, during a test which serves to determine the disconnection current ($I_\Delta$) of the residual-current breaker, increases in equal steps, at fixed time intervals, preferably from 0.3 $I_{\Delta N}$ to $I_{\Delta N1}$.

15. Circuit for carrying out the measuring method according to any one of the preceding claims, characterized in that a controlled full-wave rectifier (3) is connected to two network voltage connections (L1, PE), and supplies a rectified alternating voltage ($U_E$) to the input of an integrator (4), the output voltage ($U_A$) of which is connected to an A/D converter (5) and, moreover, a computer (7) processes the output signal of the A/D converter (5) and, in dependence thereon and on the output signal of a zero detector (6), controls the integrator (4), the full-wave rectifier (3), and a load branch (S5, 1, 2) in synchronism with the network, the load branch (S5, 1, 2) connected to the two network connections (L1, PE) consisting of a switch (S5) controlled by the computer (7) by means of a relay (K1), a programmable constant-current circuit (1) and a current monitor (2), connected in series.

16. Circuit according to Claim 15, characterized in that the full-wave rectifier (3) comprises two controllable switches (S1, S2) which are connected to its output, and of which the first switch (S1) is connected directly to the tap of a voltage divider (R1, R2) connected to the network connections (L1, PE), whilst the second switch (S2) is connected to the tap by means of an inverting amplifier (VI, R3, R4).

17. Circuit according to Claim 15 or Claim 16, characterized in that the integrator (4) comprises third and fourth controllable switches (S3, S4), the input of the third switch (S3) being able to be short-circuited to a reference potential (PE) and the fourth switch (S4) bypassing its charging capacitor (C1).

**Revendications**

1. Procédé de mesure pour le contrôle de mesures de protection dans des réseaux à tension alternative, dans lequel la tension de contact ($U_B$) et, le cas échéant, d'autres grandeurs à mesurer, sont déterminées au moyen d'un courant constant ($I_K$) fourni par l'intermédiaire des bornes d'alimentation par le réseau et agissant comme une charge réglable, et dans lequel l'intervalle de temps, pendant lequel un courant peut circuler, est limité à une valeur limite supérieure qui, dans le cas de tensions de contact ($U_B$) au-dessus de la valeur admissible, exclut tout risque,
dans lequel

a) lors d'une opération de mesure, qui exige une durée de passage du courant qui est supérieure à ladite valeur limite, pendant le déroulement de la mesure, parallèlement à une mesure principale pour le contrôle des mesures de protection, une pluralité de mesures d'essai sont effectuées pour la détermination de la tension de contact ($U_B$) à escompter ;

b) après chaque mesure d'essai, une valeur d'essai est déterminée, qui représente approximativement la tension de contact ($U_B$) à escompter ;

c) dans le cas d'une tension de contact ($U_B$) trop élevée, déterminée par une mesure d'essai, il s'ensuit une interruption du courant constant ($I_K$), et

d) l'intervalle de temps d'une mesure d'essai à la suivante, plus le temps d'interruption supplémentaire, le cas échéant, pour le courant constant ($I_K$) est plus petit que ladite valeur limite supérieure de la durée de passage du courant.

2. Procédé de mesure selon la revendication 1, caractérisé en ce que les valeurs à mesurer nécessaires pour la mesure d'essai sont prélevées et évaluées après l'écoulement d'une période du courant constant ($I_K$).

3. Procédé de mesure selon l'une des revendications précédentes, caractérisé en ce que l'intervalle de temps depuis le début du passage du courant jusqu'à son interruption, dans le cas d'une tension de contact ($U_B$) trop élevée, est inférieur à deux périodes et de préférence inférieur à 1,5 période du courant constant ($I_K$).

4. Procédé de mesure selon l'une des revendications précédentes, caractérisé en ce que, lors d'une détermination de la grandeur à mesurer selon le procédé de diminution de tension, la tension du réseau redressée est intégrée pendant une période en marche à vide et est neutralisée pendant une période suivante lors d'une charge prédéterminée par un courant constant ($I_K$), et la tension de sortie ($U_A$) restante, à l'issue de ce cycle d'intégration, à la sortie de l'intégrateur (4) servant en tant que valeur d'essai pour la mesure d'essai.

5. Procédé de mesure selon l'une des revendications précédentes, caractérisé en ce que la tension de sortie ($U_A$) de l'intégrateur (4) est comparée à une valeur limite ($U_{BL}$) qui représente la tension de contact ($U_B$) encore admissible et en ce qu'il se produit une interruption du courant constant ($I_K$) lorsque la tension de sortie ($U_A$) est supérieure à la valeur limite ($U_{BL}$).

6. Procédé de mesure selon l'une des revendications précédentes, caractérisé en ce qu'une première valeur limite ($U_{BL1}$), qui est prédéterminée en liaison avec une première tension de sortie ($U_{A1}$) dans un premier cycle d'intégration, est doublée dans un deuxième cycle d'intégration avec une deuxième tension de sortie ($U_{A2}$) pour donner une deuxième valeur limite ($U_{BL2}$) et est triplée dans un troisième cycle d'intégration, de telle manière qu'après n cycles d'intégration, on obtienne la valeur limite $U_{BLn} = n \cdot U_{BL1}$.

7. Procédé de mesure selon l'une des revendications précédentes, caractérisé en ce que le courant constant ($I_K$) est de nouveau établi, chaque fois pour la durée d'une demi-onde, lors de l'arrivée au passage par zéro et en ce qu'une interruption du courant constant ($I_K$) se produit par une suppression de l'impulsion de fermeture.

8. Procédé de mesure selon l'une des revendications précédentes, caractérisé en ce que, lors d'un contrôle du comportement à la coupure de disjoncteurs à courant de défaut, une mesure pilote est effectuée pour détecter la tension du réseau en marche à vide, la tension à vide ($U_{A1}$) intégrée pendant une demi-onde est mémorisée et en ce que la mesure pilote est suivie d'autres mesures de la tension du réseau, désormais pendant une charge avec un courant constant ($I_K$), la tension du réseau étant de nouveau intégrée chaque fois pendant une demi-onde et la tension en charge ($U_{A2}$), mesurée dans la demi-onde concernée, est comparée à la tension à vide ($U_{A1}$) mémorisée.

9. Procédé de mesure selon l'une des revendications précédentes, caractérisé en ce que la valeur du courant constant ($I_K$) est programmable et en ce que le courant constant est établi de manière répétée avec chaque demi-onde tant que cela n'est pas arrêté par une coupure de sécurité ou après la fin du contrôle du disjoncteur à courant de défaut avec pour résultat la coupure de sécurité, aussitôt que la tension différentielle entre la tension à vide ($U_{A1}$) et la tension en charge ($U_{A2}$) dépasse la valeur encore admissible de la tension de contact ($U_B$).

10. Procédé de mesure selon l'une des revendications précédentes, caractérisé en ce que, à une première demi-onde du courant constant ($I_K$), pendant laquelle se déroule l'intégration pour la détermination de la tension en charge ($U_{A2}$), fait suite une phase d'évaluation pour la détermination de la tension différentielle et de son estimation par rapport à la tension de contact admissible ($U_B$), et pendant la phase d'évaluation, s'étendant sur une demi-onde, il se produit chaque fois une neutralisation de la tension de sortie ($U_A$) de l'intégrateur.

11. Procédé de mesure selon l'une des revendications précédentes, caractérisé en ce que, dans le cas du dépassement de la tension de contact admissible ($U_B$) par la tension différentielle déterminée ($U_{A1}$ - $U_{A2}$), la valeur par conséquent dangereuse n'est signalée que lorsqu'un contrôle a prouvé que la tension du réseau est encore appliquée.

12. Procédé de mesure selon l'une des revendications précédentes, caractérisé en ce que, pour clarifier le fait que le disjoncteur à courant de défaut n'a pas déconnecté une fois le contrôle terminé avec le courant constant ($I_K$) prédéterminé, dans les limites du temps prescrit et donc qu'il doit en résulter un message de défaut, il est d'abord déterminé d'un courant constant ($I_K$) passe encore.

13. Procédé de mesure selon l'une des revendications précédentes, caractérisé en ce que le disjoncteur à courant de défaut reçoit un courant constant ($I_K$) qui pendant un essai, servant à la détermination du temps de coupure, maintient intacte la valeur de 100 % du courant nominal de coupure ($I_{\Delta N}$) du disjoncteur à courant de défaut.

14. Procédé de mesure selon l'une des revendications précédentes, caractérisé en ce que le disjoncteur à courant de défaut reçoit un courant constant ($I_K$) qui, pendant un contrôle servant à déterminer le courant de coupure ($I_\Delta$) du disjoncteur à courant de défaut, croit avec des intervalles temporels fixes par gradins égaux, de préférence de 0,3 $I_{\Delta N}$ à $I_{\Delta N1}$.

15. Disposition de circuit pour la mise en oeuvre du procédé de mesure selon l'une des revendications précédentes, caractérisée en ce qu'il est disposé au niveau de deux bornes d'alimentation par le réseau (L1, PE) un redresseur pleine onde (3) commandé qui fournit une tension alternative redressée ($U_E$) à l'entrée d'un intégrateur (4) dont la tension de sortie ($U_A$) est reliée à un convertisseur A/N (5) et en ce que, en outre, un ordinateur (7) traite le signal de sortie du convertisseur A/N (5) et en fonction de cela et du signal de sortie d'un détecteur de passage par zéro (6) commande l'intégrateur (4), le redresseur pleine onde (3) et une branche de charge (S5, 1, 2) de manière synchrone avec le réseau, dans laquelle la branche de charge (S5, 1, 2) adjacente aux deux bornes d'alimentation par le réseau (L1, PE) consiste en un montage en série d'un interrupteur (S5) commandé par l'ordinateur (7) par l'intermédiaire d'un relais (K1), en un montage à courant constant (1) programmable et en un élément de contrôle de courant (2).

16. Disposition de circuit selon la revendication 15, caractérisée en ce que le redresseur pleine onde (3) est muni de deux interrupteurs (S1, S2), agencés de manière à pouvoir être commandés, reliés à sa sortie, le premier interrupteur (S1) étant directement disposé au niveau de la prise d'un diviseur de tension (R1, R2) connecté aux bornes d'alimentation par le réseau (L1, PE) tandis que le deuxième interrupteur (S2) est relié, par l'intermédiaire d'un amplificateur inverseur (V1, R3, R4) à la prise.

17. Disposition de circuit selon la revendication 15 ou 16, caractérisée en ce que l'intégrateur (4) est muni d'un troisième et d'un quatrième interrupteurs (S3, S4) agencés de manière à pouvoir être commandés, le troisième interrupteur (S3) pouvant court-circuiter son entrée par rapport à un potentiel de référence (PE) et le quatrième interrupteur (S4) shuntant son condensateur de charge (C1).

Meßverfahren nach der Spannungsabsenkungsmethode

1.) Vorprüfung: Messung der Spannung L-PE

| | |
|---|---|
| Startbedingung<br>S1,S2 aus; S3,S4 ein | Integrator<br>neutralisieren |
| positiver Nulldurchgang<br>S1 ein; S3,S4 aus | |
| negativer Nulldurchgang<br>S1 aus; S2 ein | n Halbwellen<br>aufintegrieren |
| Anzahl der vorgesehenen<br>Durchläufe erfüllt<br>ja \| nein | |
| S3 ein; S2 aus | Integrator Hold |
| Spannung $U_A$ messen | Integratorspannung<br>messen |
| $U_N - 10\% > U > U_N + 15\%$<br>ja \| nein | Freigabeentscheidung |

2.) Ermittlung von $U_B$, $R_{Schl.}$, $R_I$ oder $R_E$

| | |
|---|---|
| S1,S2 aus; S3,S4 ein | Integrator<br>neutralisieren |
| Konstantstromschaltung<br>programmieren | Größe des zum Meßvorgang<br>benötigten Stromes fest-<br>legen |
| Relais ein | Konstantstromschaltung 1<br>ans Netz legen |
| positiver Nulldurchgang<br>S1 ein; S3,S4 aus | |
| negativer Nulldurchgang<br>S1 ein; S2 aus | unbelastete Vollwelle<br>aufintegrieren |

a                    b

Ablaufdiagramm 1A

```
        a                    b

┌──────────────────────────┐              belastete Vollwelle
│ positiver Nulldurchgang   │                 abintegrieren
│ Start Konstantstrom I_K   │
│   (1. Halbwelle)          │
└──────────────────────────┘

┌──────────────────────────┐
│ negativer Nulldurchgang   │
│    S1 ein; S2 aus         │
│      Start I_K            │          ── ── ── ── ── ── ──
│    (2. Halbwelle)         │
└──────────────────────────┘              Integrator Hold

┌──────────────────────────┐          ── ── ── ── ── ── ──
│ S3 ein; S1, S2 aus        │
└──────────────────────────┘          Sicherheitsabfrage oder
                                            Meßergebnis
┌──────────────────────────┐          ── ── ── ── ── ── ──
│ Spannung U_A messen       │          Integrator aktivieren
└──────────────────────────┘
                                       ── ── ── ── ── ── ──
┌──────────────────────────┐
│ S1 ein ; S3 aus           │
└──────────────────────────┘
                                       Auswertung der Sicher-
┌──────────────────────────┐              heitsabfrage
│    U_A  >   U_BL           │
├─────────────┬─────────────┤          ── ── ── ── ── ── ──
│    ja       │    nein      │
└─────────────┴─────────────┘          Sicherheitsabschaltung
┌──────────────────────────┐
│      I_K aus              │
│    Relais aus             │
│ Meldung U_B gefährlich    │          ── ── ── ── ── ── ──
└──────────────────────────┘
┌──────────────────────────┐
│ Ist die Anzahl der vor-   │          Steuerung der Meßzyklen
│ gegebenen Durchläufe      │
│    erfüllt                │
├─────────────┬─────────────┤          ── ── ── ── ── ── ──
│    ja       │    nein      │
└─────────────┴─────────────┘
┌──────────────────────────┐          Meßwertverarbeitung zur
│ Meßergebnis speichern     │          Ermittlung von U_B, R_Schl,
│    oder anzeigen          │              R_I oder R_E
└──────────────────────────┘          ── ── ── ── ── ── ──
┌──────────────────────────┐          Konstantstromschaltung vom
│      I_K aus              │               Netz trennen
│    Relais aus             │
└──────────────────────────┘          ── ── ── ── ── ── ──
┌──────────────────────────┐
│ Limitwert U_BL            │          Limitwert     dem
│    erhöhen                │          nächsten Durchlauf
└──────────────────────────┘               anpassen
```

Ablaufdiagramm 1B

Ermittlung der Auslösezeit von FI-Schaltern mit gleichbleibendem
Konstantstrom

1.) Pilotmessung: Messung der Spannung L-PE ($U_{A1}$)

| | |
|---|---|
| Startbedingung<br>S1,S2 aus; S3, S4 ein | Integrator neutralisieren |
| positiver Nulldurchgang<br>S1 ein; S3, S4 aus | Aufintegration einer<br>positiven Halbwelle |
| negativer Nulldurchgang<br>S2 ein; S1 aus | Integrator Hold |
| $U_{A1}$ messen | Spannung $U_{A1}$ messen und<br>abspeichern |
| S4 ein | Integrator neutralisieren |

2. FI-Schaltertest, Prüfung mit Konstantstrom $I_K = I_{\triangle N}$
(Dauer 200 ms bzw. 500 ms)

| | |
|---|---|
| Konstantstromschaltung<br>programmieren | Größe des zum Prüfvorgang<br>benötigten Stromes $I_K$<br>festlegen |
| Relais ein | Konstantstromschaltung ans<br>Netz legen |
| positiver Nulldurchgang<br>S1 ein; S3,S4 aus<br>Start Konstantstrom $I_K$ | Integrator aktivieren<br>Strom $I_K$ einschalten<br>für eine Halbwelle |
| negativer Nulldurchgang<br>S3 ein; S1 aus<br>Start Konstantstrom $I_K$<br>Spannung $U_{A2}$ messen<br>S4 ein | Integrator Hold<br>Strom $I_K$ einschalten f.<br>eine Halbwelle<br>Spannung $U_{A2}$ messen<br>Integrator neutralisieren |
| Differenzbildung<br>$U_{A1} - U_{A2}$ | Ermittlung der Berührungs-<br>spannung |
| Differenz > $U_{Bzul.}$ <br> ja \| nein | Auswertung<br>Sicherheitsabfrage |
| $I_K$ aus<br>Relais aus | Sicherheitsabschaltung |

c          d   e

Ablaufdiagramm 2A

15

| Spannungsmessung | | Messung der Spannung L-PE |
| Netzspannung noch vorhanden | | Prüfung ob FI-Schalter ausgelöst oder $U_B$ zu groß |
| ja | nein | |

Meldung $U_B$ gefährlich — Meldung $U_B$ zu groß

FI-Schalter hat ausgelöst — Schaltertest gut

| Stromfluß vorhanden | | Stromüberwachung |
| nein | ja | |

| Anzahl der vorgesehenen Durchläufe erfüllt | | Meßablaufkontrolle |
| ja | nein | |

FI-Schalter löst nicht aus — Fehlermeldung

$I_K$ aus
Relais aus — Konstantstromschaltung vom Netz trennen

Ablaufdiagramm 2B

Ermittlung des Auslösestromes von FI-Schaltern mit stufig steigendem
Konstantstrom $I_K$

| | |
|---|---|
| Messung u. Speicherung von $U_{BN}$ nach Ablaufdiagramm 1 | |
| Pilotmessung nach Ablaufdiagramm 2 zur Ermittlung von $U_{A1}$ | |
| S1, S2 aus; S3,S4 ein | Integrator neutralisieren |
| Konstantstrom ein und programmieren | Größe des zum Start des Prüfvorganges benötigten Stromes festlegen |
| Durchlaufzähler mit 30 vorladen | Meßablauf enthält 70 Schritte von $I_K=0,3I_{\triangle N}$ bis $I_K=I_{\triangle N}$ |
| Relais ein | Konstantstromschaltung ans Netz legen |
| positiver Nulldurchgang S1 ein; S3,S4 aus Start Konstantstrom | Integrator aktivieren Konstantstrom starten eine Halbwelle |
| negativer Nulldurchgang S3 ein; S1 aus Start Konstantstrom Spannung $U_{A2}$ messen S4 ein | Integrator Hold Konstantstrom starten eine Halbwelle Spannung $U_{A2}$ messen Integrator neutralisieren |
| Differenzbildung $U_{A1}-U_{A2}$ | Ermittlung der Berührungs- spannung |
| Differenz $> U_{B\ zul.}$ ja \| nein | Auswertung Sicherheitsabfrage |
| Konstantstrom aus Relais aus | Sicherheitsabschaltung |
| Spannungsmessung | Messung der Spannung L-PE |

f        g        h   j

Ablaufdiagramm 3A

EP 0 368 029 B1

| | |
|---|---|
| Netzspannung vorhanden | Prüfung ob FI-Schalter ausgelöst oder $U_B$ zu groß |
| ja / nein | |
| Meldung $U_B$ gefährlich | Meldung $U_B$ zu groß |
| positiver Nulldurchgang S1 ein; S3,S4 aus Start Konstantstrom | Integrator aktivieren Konstantstrom starten für eine Halbwelle |
| negativer Nulldurchgang S3 ein; S1 aus Start Konstantstrom Spannungsmessung $U_{A2}$ S4 ein | Integrator Hold Konstantstrom starten eine Halbwelle Spannung $U_{A2}$ messen Integrator neutralisieren |
| Differenzbildung $U_{A1}-U_{A2}$ | Auswertung der Sicherheitsabfrage |
| Differenz$>$ $U_{B\ zul.}$ ja / nein | Auswertung Sicherheitsabfrage |
| Durchlaufzähler $\geq$ 100 ja / nein | Abfrage ob Meßablauf beendet |
| Spannungsmessung | Messung der Spannung L-PE |
| Netzspannung vorhanden ja / nein | Prüfung ob FI-Schalter ausgelöst hat |
| FI-Schalter löst nicht aus | Fehlermeldung |
| Konstantstrom aus Relais aus | Konstantstromschaltung vom Netz trennen |
| Durchlaufzähler +1 | Durchlaufzählerstand ist Maß für Stromgröße |
| Konstantstrom $I_K$ um $I_{\Delta N} \cdot 0,01$ erhöhen | Konstantstrom erhöhen |

Ablaufdiagramm 3B

18

k       ·1   m

| Stromfluß vorhanden | |
|---|---|
| nein | ja |

Abfrage ob FI-Schalter
ausgelöst

---

Ermittlung von $U_{BF}$
beim Auslösestrom

$$U_B = U_{BN} \cdot \frac{DL\text{-}Zähler}{100}$$

Ermittlung der Meßwerte

Ermittlung des Auslösestromes

$$I_A = I_{\Delta N} \cdot \frac{DL\text{-}Zähler}{100}$$

---

Konstantstrom aus
Relais aus

Konstantstromschaltung
vom Netz trennen

Ablaufdiagramm 3C

Fig. 1

Fig. 2

EP 0 368 029 B1

Fig. 3

Fig. 4